# EUROPEAN PATENT SPECIFICATION

(11) **EP 0 481 706 B1**
(45) Date of publication and mention of the grant of the patent: **12.04.1995**
(21) Application number: 91309441.3
(22) Date of filing: 15.10.1991
(51) Int. Cl.: H01L 21/314, C23C 16/30

(54) **Method of producing CVD silicon oxynitride film**
Erzeugungsmethode einer CVD-Silizium-Oxynitridschicht
Méthode de production d'un film CVD d'oxynitrure de silicium

(30) Priority: 16.10.1990 JP 275264/90
(43) Date of publication of application: 22.04.1992
(73) Proprietor: KAWASAKI STEEL CORPORATION, Chuo-Ku, Kobe-Shi Hyogo-Ken (JP)
(72) Inventor: Sato, Nobuyoshi, c/o Kawasaki Steel Corporation, Chiba City, Chiba Pref. (JP)
(74) Representative: Overbury, Richard Douglas

(56) References cited:
- US-A- 4 158 717
- US-A- 4 992 306
- PATENT ABSTRACTS OF JAPAN,vol. 13, no. 413 (E-820)12 September 1989 & JP-A-1 152 631 ( NEC ) 15 June 1989
- PATENT ABSTRACTS OF JAPAN, vol. 11, no. 81 (E-488)12 March 1987 & JP-A-61 234 534 ( SEMICONDUCTOR ENERGY LAB ) 18 October 1986

## Description

The present invention generally relates to a method of producing an insulating film for use as an insulating film provided on a semiconductor substrate, an interlayer insulating film and an outermost passivation film of a semiconductor device, and more particularly to a method of producing a CVD silicon oxynitride (SiON) film.

In semiconductor devices, various kinds of insulating films are used. For instance, an interlayer insulating film is arranged between metal layers and a passivation film is provided on an outermost surface of the semiconductor device. Usually such insulating films are formed of silicon oxide (SiO₂), phosphosilicate glass (PSG), borophosphosilicate glass (BPSG), silicon nitride (Si₃N₄), and silicon oxynitride (SiON). Silicon oxide, phosphosilicate glass and borophosphosilicate glass have small dielectric constants and superior insulating properties, but have poor wetproof properties. Silicon nitride has a superior wetproof property, but its dielectric constant is high.

Silicon oxynitride has intermediate characteristics between silicon oxide and silicon nitride, so that it is possible to obtain an insulating film which has superior wet-proof and insulating properties as well as a low dielectric constant by suitably selecting its composition. Due to this, many attempts and proposals have been made to use silicon oxynitride film as a protecting passivation film and an insulating interlayer film in semiconductor devices.

In a known method of producing the silicon oxynitride film, a mixture of mono-silane (SiH₄), nitrous oxide (N₂O) and ammonia (NH₃) is introduced into a reaction vessel and the silicon oxynitride film is deposited on a semiconductor wafer by plasma CVD whereby electrical energy is supplied to the reactants.

In this known method of forming the silicon oxynitride film, a main composition of the reaction gas, i.e. mono-silane, is poisonous, so that its treatment is cumbersome and safety precautions are required. Further, in plasma CVD, a surface of a semiconductor wafer is exposed to plasma gas and thus it might be damaged by high energy electrons and charged particles. Due to this, the electrical properties of the semiconductor device might be deteriorated and damaged and the manufacturing yield might be decreased.

In Japanese Patent Publications Kokai Hei Nos. 1-152631 published on June 15, 1989, 1-238024 published on September 22, 1989, 1-239940 published on September 25, 1989 and 1-260833 published on October 18, 1989, there are proposed other known methods, in which a silicon oxynitride film is produced without using the poisonous mono-silane.

In the known method disclosed in Japanese Patent Publication Kokai Hei No. 1-152631, it is possible to form a silicon oxynitride film at a relatively low temperature such as 350°C by using a reaction gas containing an organic silane gas, ozone gas and an ammonia gas. In this known method, radiation energy is supplied to the reactants in the form of ultraviolet radiation having a wavelength shorter than 300 nm. This requires a large and expensive ultraviolet radiation exposing device and the reaction vessel must have a window through which the ultraviolet radiation is made incident. Further, in radiation CVD, the deposition rate is low, for example 10 to 20nm (100 to 200 Å) per minute.

In the known method described in Japanese Patent Publication Kokai Hei No. 1-238024, a mixture of an organic silane gas and nitrogen gas is introduced into a reaction vessel and nitrogen plasma CVD is carried out under a low pressure such as 2 Torr. In this method, the substrate is subjected to the nitrogen plasma and thus the electrical property of the semiconductor device may be deteriorated.

In the method of Japanese Patent Publication Kokai Hei No. 1-239940, a mixture of an organic silane gas and ammonia gas is introduced into a reaction vessel and a low pressure plasma CVD silicon oxynitride film is deposited on a substrate. This method has the drawback that the substrate surface is damaged by the bombardment of the plasma particles.

In the method disclosed in Japanese Patent Publication Kokai Hei No. 1-260833, a mixture of an organic oxy silane gas and ammonia gas is introduced into a reaction vessel which is kept at a low pressure such as 70 to 200 Pa (0.5 to 1.5 Torr), while a semiconductor wafer is heated at a relatively high temperature such as 750 to 800°C. It is known to use metal wiring conductors formed of aluminium whose softening temperature is about 450°C. Thus this known method could not be applied to semiconductor devices comprising an aluminium wiring pattern. Moreover, since reduced pressure is utilized, the step coverage is poor and it is rather difficult to obtain an insulating film having a flat surface.

In the above mentioned known methods which do not use the poisonous mono-silane gas, a mixture mainly consisting of the organic silane such as tetra ethoxy silane (TEOS) and the ammonia or nitrogen gas is utilized, so that the deposited silicon oxynitride film hardly has a desired composition.

Freeman and Kern (Journal of Vacuum Science and Technology A 1446, 7(3), 1989) disclose the use of HMDS (hexamethyldisilazane) as an effective single-source reactant of Si, N and C for low pressure CVD at temperatures of around 800°C to produce dielectric films suitable for electronics applications. The authors investigated the pyrolytic low pressure CVD of HMDS alone, and in combination with oxygen, nitrous oxide, ammonia and ammonia-oxygen atmospheres. This method suffers the disadvantage that substrates bearing low temperature melting conductors are excluded due to the high temperatures required to form the dielectric film.

The present invention has for its object to provide a novel and useful method of producing a silicon oxynitride film having a desired composition safely without using the poisonous mono-silane, and without heating the substrate to a temperature at which the aluminium wiring pattern is softened.

According to the present invention there is provided a method of producing a CVD film on a semiconductor substrate comprising the steps of:
placing the semiconductor substrate in a reaction vessel;
heating the semiconductor substrate at a temperature of from 150 to 450°C; and
introducing a mixture of a nitrogen-containing organic silane gas and ozone gas into the reaction vessel to deposit an insulating silicon oxynitride film on the semiconductor substrate by chemical vapour deposition wherein said nitrogen-containing organic silane gas is formed of (CH₃)₃SiNHSi(CH₃)₃ or (CH₃)₃SiN(C₂H₅)₂ or (CH₃)₃SiNHCOCH₃ or (CH₃)₃SiN(CH₃)₂ or (CH₂=CH)(CH₃)₂SiN(CH₃)₂ and the method is carried out without supplying electric or radiation energy to the reactants.

In a preferred embodiment of the method according to the invention, the reaction vessel is kept at atmospheric pressure.

In the method according to the invention, a mixture of nitrogen containing silane gas and ozone gas is used as the reaction gas and it is not necessary to use the poisonous mono-silane so that the method can be performed safely. Furthermore, the silicon oxynitride film is formed at a temperature not higher than 450°C, and therefore the metal wiring pattern formed on the substrate is not damaged. Therefore, the silicon oxynitride film formed by the method according to the invention can be advantageously used as an interlayer insulating film as well as an outermost protecting passivation film of a semiconductor wafer.

For a better understanding of the invention, and to show how the invention may be carried into effect, reference will now be made, by way of example, to the accompanying drawings, in which:
Fig. 1 is schematic view showing an embodiment of an apparatus for carrying out the method according to the invention;
Fig. 2 is a cross sectional view illustrating a transistor including an insulating film formed by the method according to the invention; and
Fig. 3 is a graph representing the variation of the mutual conductance of the transistor shown in Fig. 2.

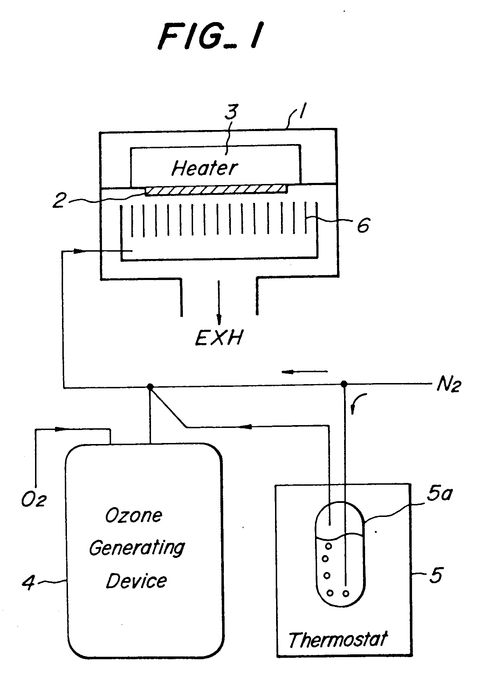

Fig. 1 is a schematic view showing an embodiment of an apparatus for carrying out the method of producing the silicon oxynitride film according to the invention. The apparatus comprises a reaction vessel 1 and an electric heater 3 provided in the reaction vessel 1. A silicon wafer 2 is installed in the reaction vessel 1 and is heated at a desired temperature. The apparatus further comprises an ozone generating device 4 and a thermostat 5. In the thermostat 5, there is arranged a gas bubbler 5a which contains a nitrogen-containing organic silane material and through which nitrogen gas is supplied to generate a nitrogen-containing organic silane gas. The nitrogen gas is also used as a carrier gas. It should be noted that the carrier gas may consist of other inert gases such as Ar and He. The ozone gas generated by the ozone generating device 4, the nitrogen-containing organic silane gas generated by the gas bubbler 5a in the thermostat 5 and the nitrogen carrier gas are supplied to the reaction vessel 1. In the reaction vessel 1 there are further arranged vanes 6 for regulating the mixture gas so that a laminated gas stream can be projected against the silicon wafer 2.

### Example 1

A silicon wafer 2 in which an MOS transistor having a gate having a length of 1 »m and a width of 20 »m was formed, was placed in the reaction vessel 1. A mixture containing the ozone gas and the nitrogen-containing organic silane gas (CH₃)₃SiNHSi(CH₃)₃ was introduced into the reaction vessel 1 and the pressure inside the reaction vessel was maintained at atmospheric pressure. The nitrogen-containing organic silane gas and the ozone gas were supplied at rates of 100 cc/min and 3 cc/min, respectively. The silicon wafer 2 was heated by the heater 3 at a temperature of 400°C. The deposition was performed for ten minutes. The temperature inside the reaction vessel 1 was about 370°C and the gas bubbler 5a arranged in the thermostat 5 was kept at a temperature of 100°C. The flow rate of O₂ gas into the ozone generating device 4 was set to 4 liters per minute, the flow rate of the nitrogen gas into the gas bubbler 5a in the thermostat 5 was set to 1 liter per minute, and the nitrogen gas flow rate into the reaction vessel 1 was set to 20 liters per minute. The ozone gas generating factor in the ozone generating device 4 was 5%. In this manner, on the silicon wafer surface there was formed a silicon oxynitride film having a thickness of about 700nm (7000 Å).

### Comparative Example 1

Similar to the above mentioned example 1, a silicon wafer in which an MOS transistor including a gate having a length of 1 »m and a width of 20 »m was formed, was placed in a low pressure CVD device and a mixture of a mono-silane gas and ammonia gas was introduced into the reaction vessel. A high frequency electric power was supplied to the reaction space and the plasma vapour deposition was carried out to produce a silicon oxynitride film serving as a passivation film.

In order to estimate the property of the silicon oxynitride films formed by the method according to the invention, the variation in the mutual conductance gm under stress was measured.

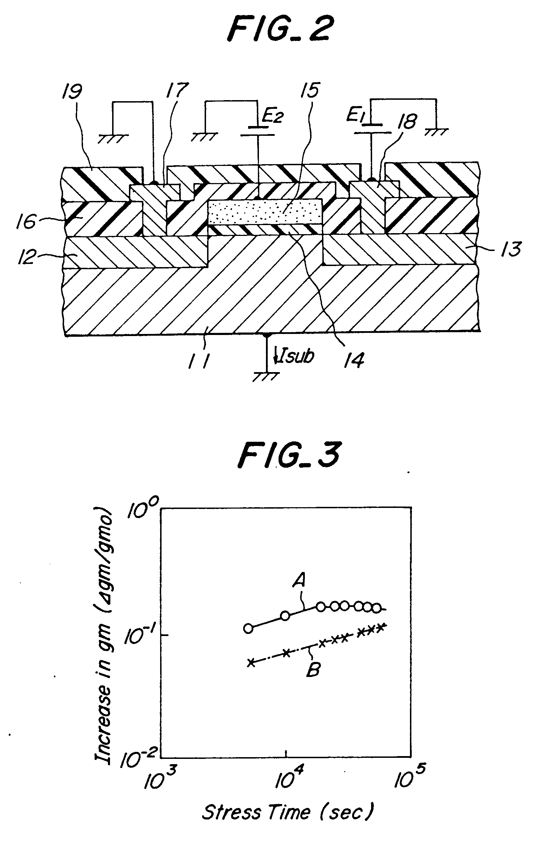

The N-channel MOS transistors including the silicon oxynitride films formed by the method according to the invention and by the known method were connected to bias voltage sources E₁ and E₂ as shown in Fig. 2. The transistor comprised a silicon substrate 11, source and drain regions 12 and 13 formed in the surface of the substrate 11, a gate oxide film 14, a polysilicon gate electrode 15, a BPSG film 16, aluminum electrodes 17, 18 and an insulating silicon oxynitride film 19. The gate had a W/L value of 20 »m/1 »m.

The source electrode 17 was connected to the ground potential and the drain electrode 18 was connected to a drain bias voltage source E₁ of 7.5 V. The gate electrode 15 was connected to a gate bias voltage source E₂ and the silicon substrate 11 was connected to the ground potential. After the above mentioned accelerating test using 7.5 V, the gate bias voltage source E₂ was set to such a value that the substrate current I_{sub} became a maximum under the drain voltage of 2.0 V. The above mentioned bias condition was continued for 14 hours and the variation of the mutual conductance gm calculated from drain current (I_{D})/gate voltage (V_{G}) was monitored.

Fig. 3 is a graph showing the results of the above experiments. The horizontal axis denotes stress time and the vertical represents the relative variation in the mutual conductance gm (Δgm/gm₀). gm₀ is the initial mutual conductance and Δgm is the difference between the current mutual conductance and the initial mutual conductance. The curve A denotes the variation of the mutual conductance of the silicon oxynitride formed by the method according to the invention and the curve B represents the variation of the mutual conductance of the silicon oxynitride film formed by the known method.

As can be understood by comparing the curves A and B illustrated in Fig. 3, the decrease of the mutual conductance of the passivation film produced by the method according to the invention is smaller than that of the film formed by the known method. In the plasma CVD silicon oxynitride film produced by the known method, the substrate surface just below the gate is damaged by the ion bombardment and the substrate is charged up. The mutual conductance gm is calculated from I_{D}/V_{G} , and in the comparative example 1, the drain current I_{D} is reduced due to the ion bombardment and charge-up of the substrate, so that the mutual conductance is decreased. In the method according to the invention, the silicon oxynitride film is formed without using the plasma, and therefore the above explained damage and charge-up do not occur and the mutual conductance is not hardly decreased.

In the above embodiment, (CH₃)₃SiNHSi(CH₃)₃ is used as the nitrogen-containing organic silane material, but according to the invention it is also possible to use (CH₃)₃SiN(C₂H₅)₂, (CH₃)₃SiNHCOCH₃, (CH₃)₃SiN(CH₃)₂ and (CH₂=CH) (CH₃)₂SiN(CH₃)₂.

In the above embodiment, the CVD is carried out under atmospheric pressure, but according to the invention, it is also possible to produce the silicon oxynitride film by high pressure CVD. In high pressure CVD the reaction vessel may be kept at a pressure such as 1.5 to 5 bar. Under such a high pressure, the life time of the ozone is prolonged, and thus the deposition rate is increased and the flatness of the silicon oxynitride film is improved. Also in the high pressure CVD method according to the invention, since the mixture gas includes the nitrogen-containing organic silane, the desired composition of the deposited silicon oxynitride film can be obtained.

Furthermore, in order to make the silicon oxynitride film as uniform as possible, the silicon wafer may be vibrated in the reaction vessel.

As explained above in detail, in the method of producing the silicon oxynitride film according to the invention, it is not necessary to use poisonous mono-silane, so that the process can be performed safely, Further, since the reaction is performed at a temperature not higher than 450°C, aluminum wiring conductors are not damaged during the CVD process, so that the silicon oxynitride is advantageously utilized as the outermost protecting passivation film of the semiconductor device. Moreover, when atmospheric pressure CVD is carried out, the process can be conducted easily by means of a simple apparatus. In the atmospheric pressure CVD and high pressure CVD, the substrate surface is not damaged by plasma, and therefore the property of the semiconductor device is not deteriorated. Moreover, in the high pressure CVD, the deposition rate can be increased.

## Claims

1. A method of producing a CVD film on a semiconductor substrate comprising the steps of:
placing the semiconductor substrate in a reaction vessel;
heating the semiconductor substrate at a temperature of from 150 to 450°C; and
introducing a mixture of a nitrogen-containing organic silane gas and ozone gas into the reaction vessel to deposit an insulating silicon oxynitride film on the semiconductor substrate by chemical vapour deposition wherein said nitrogen-containing organic silane gas is formed of (CH₃)₃SiNHSi(CH₃)₃ or (CH₃)₃ N(C₂H₅)₂ or (CH₃)₃SiNHCOCH₃ or (CH₃)₃SiN(CH₃)₂ or (CH₂=CH)(CH₃)₂SiN(CH₃)₂ and the method is carried out without supplying electric or radiation energy to the reactants.

2. A method according to claim 1, wherein said reaction vessel is kept at atmospheric pressure.

3. A method according to claim 1, wherein said reaction vessel is kept at a pressure higher than atmospheric pressure.

4. A method according to claim 3, wherein said reaction vessel is kept at a pressure of from 1.5 to 5 bar.

5. A method according to any of claims 1, 2, 3 or 4 wherein said mixture of the nitrogen-containing organic silane gas and ozone gas is introduced into said reaction vessel using a carrier gas.

6. A method according to claim 5, wherein said carrier gas is nitrogen gas.

7. A method according to claim 6, wherein said nitrogen-containing organic silane gas is formed by flowing the nitrogen gas through a gas bubbling device which contains the nitrogen-containing organic silane.

8. A method according to any preceding claim wherein said mixture contains the nitrogen-containing organic silane gas and ozone gas in the ratio of 100 parts by volume of organic silane gase to 3 parts by volume of ozone gas.

## Patentansprüche

1. Verfahren zur Herstellung einer CVD-Schicht auf einem Halbleitersubstrat, umfassend die Schritte: Bereitstellen von einem Halbleitersubstrat in einem Reaktor;
Erwärmen des Halbleitersubstrats auf eine Temperatur zwischen 150 und 450°C; und
Einführen einer Mischung aus stickstoffhaltigem gasförmigem Organylsilan und gasförmigem Ozon in den Reaktor, um auf dem Halbleitersubstrat durch chemische Dampfphasenabscheidung (CVD) eine isolierende Siliciumoxidnitridschicht aufzubringen, wobei das stickstoffhaltige gasförmige Organylsilan aus (CH₃)₃SiNHSi(CH₃)₃, (CH₃)₃SiN(C₂H₅)₂, (CH₃)₃SiNHCOCH₃, (CH₃)₃SiN(CH₃)₂ oder (CH₂=CH)(CH₃)₂SiN(CH₃)₂ besteht; wobei das Verfahren, ohne daß den Reaktanten elektrische oder Strahlungsenergie zugeführt wird, durchgeführt wird.

2. Verfahren nach Anspruch 1, wobei der Reaktor bei Atmosphärendruck gehalten wird.

3. Verfahren nach Anspruch 1, wobei der Reaktor auf einem Druck gehalten wird, der über Atmosphärendruck liegt.

4. Verfahren nach Anspruch 3, wobei der Reaktor auf einem Druck zwischen 1,5 und 3 bar gehalten wird.

5. Verfahren nach einem der Ansprüche 1, 2, 3 oder 4, wobei die Mischung aus einem stickstoffhaltigen gasförmigen Organylsilan und Ozon mit einem Trägergas in den Reaktor eingeleitet wird.

6. Verfahren nach Anspruch 5, wobei als Trägergas Stickstoff verwendet wird.

7. Verfahren nach Anspruch 6, wobei das stickstoffhaltige gasförmige Organylsilan durch Leiten von gasförmigen Stickstoff durch eine Gasblasen-Einrichtung, die das stickstoffhaltige Organylsilan enthält, erzeugt wird.

8. Verfahren nach einem der vorangehenden Ansprüche, wobei die Mischung stickstoffhaltiges gasförmiges Organylsilan und Ozongas im Verhältnis 100 Vol.-Teile gasförmiges Organylsilan zu 3 Vol.-Teile Ozongas enthält.

## Revendications

1. Procédé de préparation d'un film par dépôt chimique en phase vapeur sur un substrat semi-conducteur comprenant les étapes consistant
- à placer le substrat semi-conducteur dans un récipient de réaction,
- à chauffer le substrat semi-conducteur à une température comprise entre 150 et 450 °C, et
- à introduire un mélange d'un silane organique gazeux contenant de l'azote et de l'ozone gazeux dans le récipient de réaction pour déposer par dépôt chimique en phase vapeur un film isolant en oxynitrure de silicium sur le substrat semi-conducteur, dans lequel ledit silane organique gazeux contenant de l'azote est composé de (CH₃)₃SiNHSi(CH₃)₃ ou (CH₃)₃SiN(C₂H₅)₂ ou (CH₃)₃SiNHCOCH₃ ou (CH₃)₃SiN(CH₃)₂ ou (CH₂CH) (CH₃)₂SiN(CH₃)₂ et le procédé est effectué sans fournir aux réactifs de l'énergie électrique ou de l'énergie sous forme de radiations.

2. Procédé conforme à la revendication 1 dans lequel ledit récipient de réaction est maintenu à pression atmosphérique.

3. Procédé conforme à la revendication 1 dans lequel ledit récipient de réaction est maintenu à une pression supérieure à la pression atomosphérique.

4. Procédé conforme à la revendication 3 dans lequel ledit récipient de réaction est maintenu à une pression comprise entre 1,5 et 5 bar.

5. Procédé conforme à une quelconque des revendications 1, 2, 3 ou 4 dans lequel ledit mélange de silane organique gazeux contenant de l'azote et d'ozone gazeux est introduit dans le récipient de réaction à l'aide d'un gaz d'entraînement.

6. Procédé conforme à la revendication 5 dans lequel ledit gaz d'entraînement est de l'azote gazeux.

7. Procédé conforme à la revendication 6 dans lequel on forme ledit silane organique gazeux contenant de l'azote en faisant passer l'azote gazeux par un dispositif de bullage contenant le silane organique contenant de l'azote.

8. Procédé conforme à une quelconque des revendications précédentes dans lequel ledit mélange contient le silane organique gazeux contenant de l'azote et de l'ozone gazeux en un rapport de 100 parties par volume de silane organique gazeux pour 3 parties en volume d'ozone gazeux.
